# EUROPEAN PATENT APPLICATION

(11) **EP 1 956 588 A1**
(43) Date of publication of application: **13.08.2008**
(21) Application number: 08101281.7
(22) Date of filing: 05.02.2008
(51) Int. Cl.: G10L 19/14, H04S 7/00, H03G 5/02

(54) **Method and apparatus for decoding an audio signal**

(30) Priority: 07.02.2007 KR 20070012779
(71) Applicant: Samsung Electronics Co., Ltd., Suwon-si, Gyeonggi-do 442-742 (KR)
(72) Inventor: Oh, Jae-one, Gyeonggi-do (KR); Lee, Geon-hyoung, Gyeonggi-do (KR); Lee, Chul-woo, Gyeonggi-do (KR); Jeong, Jong-hoon, Gyeonggi-do (KR); Lee, Nam-suk, Gyeonggi-do (KR)
(74) Representative: Walaski, Jan Filip

(57) **Abstract**

A method of implementing an equalizer in an audio signal decoder and an apparatus therefor are provided. According to the method and apparatus, a signal output from an audio signal decoder is not processed by an equalizer, but the values of frequency components are adjusted according to a user's input before subband sample data is transformed into a frequency domain signal in an audio signal decoder, thereby implementing an equalizer in a codec. In this way, the complexity of implementing an apparatus for reproducing an audio signal can be reduced and delay of an equalizer can be reduced.

## Description

The present invention relates to processing an audio signal, and more particularly, to a method of implementing an equalizer in an apparatus for processing an audio signal.

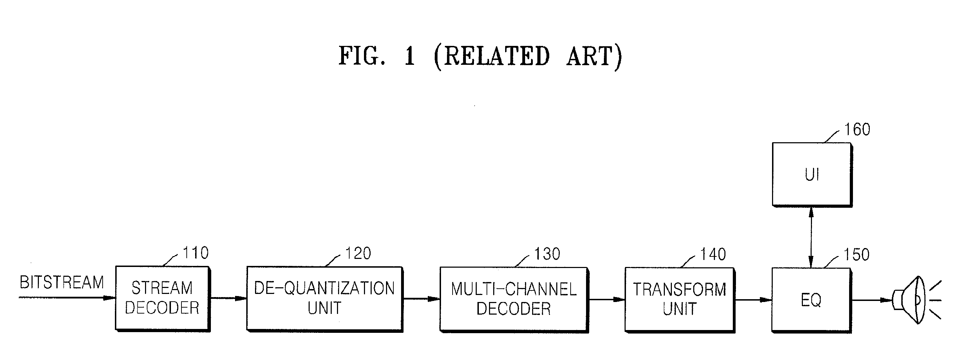

Figure 1 is a block diagram illustrating a structure of a related art apparatus for reproducing an audio signal according to conventional technology.

A stream decoder 110 analyzes and parses a bitstream obtained by encoding an audio signal, and a de-quantization unit 120 de-quantizes a value output from the stream decoder 110.

A multi-channel decoder 130 decodes a value output from the de-quantization unit 120, and outputs subband sample data for each of a plurality of channels. Subband encoding is a well-known encoding method used in many codecs for encoding efficiency, and a subband encoded audio signal is decoded in units of subbands. A transform unit 140 generates information on components in the entire frequency band from the subband sample data, transforms the generated information on the frequency components into an audio signal in the time domain by using inverse fast Fourier transform (IFFT) or inverse modified discrete cosine transform (IMDCT), and restores the original audio signal.

An equalizer 150 transforms the time domain signal into a frequency domain signal again, analyzes frequency components included in the audio signal, and adjusts the amplitude of each of the frequency band components according to a value input by a user through a user interface 160. That is, by adjusting the frequency components of the audio signal through the equalizer 150, the user can generate a sound to suit his/her preference. The equalizer 150 transforms the amplitudes of frequency components adjusted by the user's input, outputs the transformed signal, and displays the adjusted amplitudes of the frequency components to the user through the user interface 160.

In this way, in the related art apparatus for reproducing an audio signal, in order to adjust the amplitudes of frequency components according to the user's input, the equalizer transforms a time domain signal obtained through decoding, again into a frequency domain signal. Also, in order to generate a signal to be output to a speaker after adjusting the amplitudes of the frequency components, information on the frequency components is transformed again into a time domain signal. In this process, the equalizer processes a large amount of signals, and thus the complexity of implementing an entire audio reproducing apparatus having the equalizer increases. Also, after the amplitudes of the frequency components are adjusted by the user through an input apparatus, in order to actually output a sound through a speaker, information on the adjusted amplitudes is transformed through IMDCT or IFFT, and this causes delay.

The present invention provides an apparatus for and method of decoding an audio signal in which information on frequency components generated from subband sample data is adjusted according to an input of a user, and the adjusted information on the frequency components is transformed into a time domain output signal.

According to an aspect of the present invention, there is provided a method of decoding an audio signal including: transforming subband sample data of an audio signal into frequency band information items; adjusting the transformed frequency band information items according to a user's input; and transforming the adjusted frequency band information items into subband sample data.

The method may further include displaying the adjusting frequency band information through a display apparatus.

The transforming of the subband sample data into the frequency band information items may include: detecting frequency components from the subband sample data; and grouping the detected frequency components with respect to frequency bands, and mapping each group to one of a predetermined number of frequency band information items.

The adjusting of the frequency band information items may include: receiving an input of an adjustment command for predetermined frequency band information item from a user; and changing the amplitudes of all the frequency components mapped onto the corresponding band information item according to the user's input, wherein in the transforming of the adjusted frequency band information items into the subband sample data, the changed frequency components are transformed into the subband sample data.

According to still another aspect of the present invention, there is provided a computer readable recording medium having embodied thereon a computer program for executing the method of decoding an audio signal.

According to another aspect of the present invention, there is provided an apparatus for decoding an audio signal including: a first transform unit transforming subband sample data of an audio signal into frequency band information items; an adjustment unit adjusting the transformed frequency band information items according to a user's input; and a second transform unit transforming the adjusted frequency band information items into subband sample data.

The apparatus may further include a display control unit displaying the adjusting frequency band information items through a display apparatus.

The first transform unit may include: a detection unit detecting frequency components from the subband sample data; and a mapping unit grouping the detected frequency components with respect to frequency bands, and mapping each group to one of a predetermined number of frequency band information items.

The adjustment unit may receive an input of an adjustment command for predetermined frequency band information item from a user, and change the amplitudes of all the frequency components mapped onto the corresponding band information item according to the user's input, and the second transform unit may transform the changed frequency components again into the subband sample data.

The above and other aspects of the present invention will become more apparent by describing in detail exemplary embodiments thereof with reference to the attached drawings in which:
Figure 1 is a block diagram illustrating a structure of a related art apparatus for reproducing an audio signal;
Figure 2 is a block diagram illustrating a structure of an audio signal decoder according to an exemplary embodiment of the present invention;
Figure 3 is a block diagram illustrating a structure of an equalizer in an audio signal decoder according to an exemplary embodiment of the present invention; and
Figure 4 is a flowchart illustrating a method of decoding an audio signal according to an exemplary embodiment of the present invention.

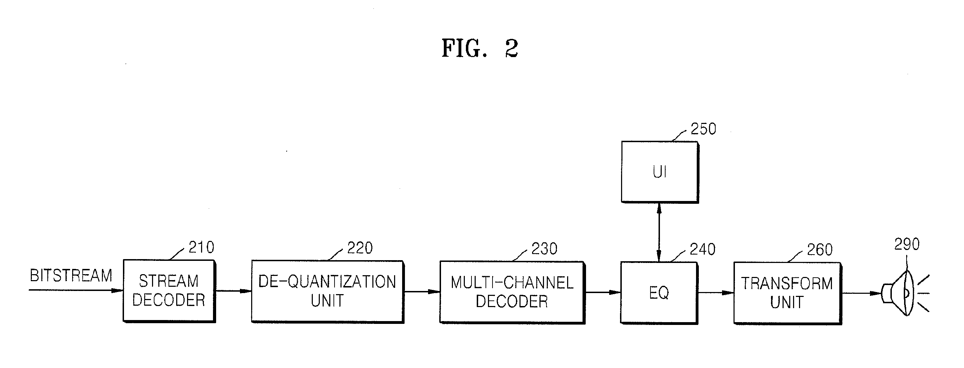

Figure 2 is a block diagram illustrating a structure of an audio signal decoder according to an exemplary embodiment of the present invention.

As illustrated in Figure 2, the audio signal decoder according to the current exemplary embodiment includes a stream decoder 210, a de-quantization unit 220, a multi-channel decoder 230, an equalizer 240, and a transform unit 260. A user interface 250 is a block separately existing from the audio signal decoder.

The stream decoder 210 analyzes and parses a bitstream obtained by encoding an audio signal, and the de-quantization unit 220 de-quantizes a value output from the stream decoder 210.

The multi-channel decoder 230 decodes a value output from the de-quantization unit 220, and outputs subband sample data for each of a plurality of channels.

The equalizer 240 transforms the subband sample data into information on frequency components, forms a predetermined number of groups of the frequency components, and transforms the frequency components into frequency band information items. In order to transform the subband sample data into information on the frequency components, the format of the subband sample data, the amplitude of a subband, and the like should be known. The format and the amplitude may vary according to a codec. Accordingly, the stream decoder 210 may read information on a codec from the header of the bitstream and transfer the information to the equalizer 240.

If the frequency band information items are adjusted, the equalizer 240 transforms the adjusted frequency band information items again into subband sample data, transfers the subband sample data to the transform unit 260, and also displays the adjusted frequency band information items to a user through the user interface 250, such as a liquid crystal display (LCD).

The transform unit 260 generates information on the components in the entire frequency band from the subband sample data, and transforms the generated information on the frequency components into a time domain audio signal by using IFFT or IMDCT, thereby producing the final audio signal. The final audio signal is output through a speaker 290.

In this way, unlike the related art technology by which an equalizer receives and processes an input of a time domain audio signal transformed from subband sample data, in the audio signal decoding apparatus according to the current embodiment, an equalizer adjusts the amplitudes of frequency components according to a user's input before subband sample data is transformed into a time domain audio signal is implemented in a codec.

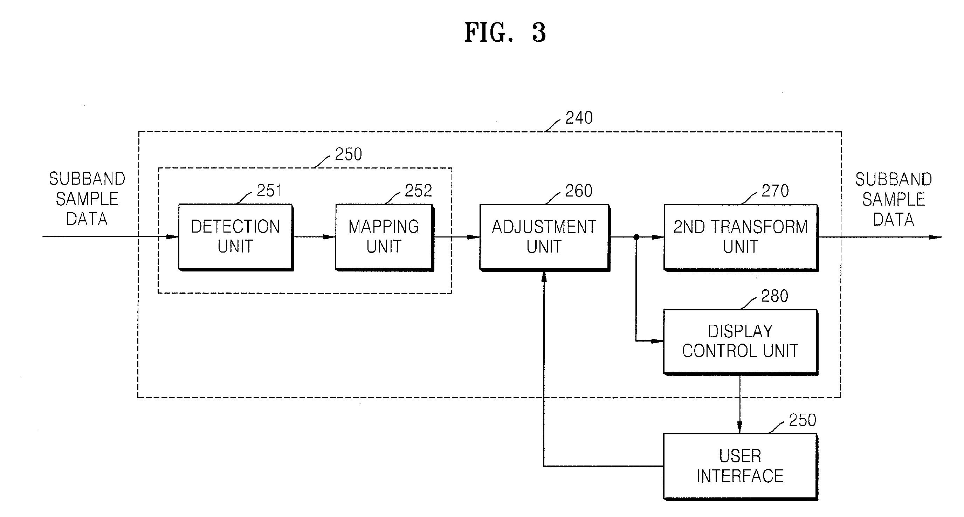

Figure 3 is a block diagram illustrating a structure of an equalizer in an audio signal decoder according to an exemplary embodiment of the present invention.

As illustrated in Figure 3, the equalizer 240 according to the current embodiment includes a first transform unit 250, an adjustment unit 260, a second transform unit 270, and a display control unit 280. The first transform unit 250 includes a detection unit 251 and a mapping unit 252.

The first transform unit 250 transforms input subband sample data into frequency band information items, and the detection unit 251 detects frequency components from the subband sample data. The subband sample data is also data of the frequency components of an audio signal, and according to a codec, the frequency components may be arranged in a matrix form or in a linear form, and the amplitude of the subband may vary. Accordingly, the detection unit 251 adaptively interprets subband sample data according to a codec, and detects the amplitude of each frequency component.

The mapping unit 252 groups each frequency component on the basis of frequency bands, and maps the frequency component onto a predetermined number of frequency band information items. Since the types of input unit allowing a user to input a value in a user interface and the amount of information that can be displayed to the user are limited, a large number of frequency components are grouped into a predetermined number of groups and made to be frequency band information items.

The adjustment unit 260 adjusts the amplitudes of the frequency components mapped onto the frequency band information items according to a user's input. The user can adjust frequency band information items of a predetermined band through the user interface 250. If the user adjusts the frequency band information item of a predetermined band, the amplitudes of all frequency components mapped onto the frequency band information items may be changed at the same time.

The second transform unit 270 transforms the frequency components changed by the adjustment unit 260 again into subband sample data. The display control unit 280 displays the adjusted frequency band information items to the user through the user interface 250.

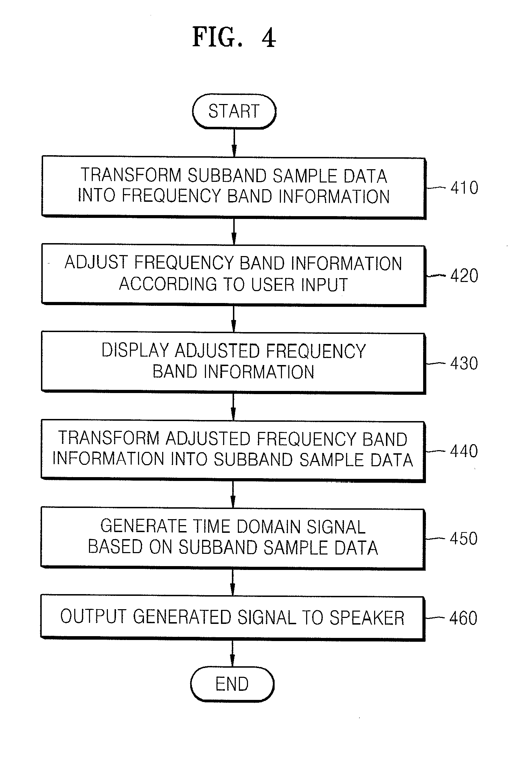

Figure 4 is a flowchart illustrating a method of decoding an audio signal according to an exemplary embodiment of the present invention.

In operation 410, subband sample data is transformed into frequency band information. As described above, in this process, frequency components are detected from the subband sample data, and grouped and then mapped onto a predetermined number of frequency band information items.

In operation 420, frequency band information items are adjusted according to a user's input. If the user adjusts predetermined frequency band information items through a user interface, all the frequency components mapped on the frequency band information items are changed at the same time.

In operation 430, the adjusted frequency band information items are displayed to the user through a user interface.

In operation 440, the adjusted frequency band information items are transformed into subband sample data.

In operation 450, based on the subband sample data, a frequency domain signal is generated, and transformed into a time domain signal, thereby generating a final signal.

In operation 460, the final signal is output through a speaker.

According to the exemplary embodiments of the present invention, an equalizer which transforms a time domain signal output from an audio signal decoder into a frequency domain signal and processes the signal according to a user's input is not required. Accordingly, the complexity of an audio reproducing apparatus having an equalizer can be reduced.

Also, since the frequency domain signal adjusted according to a user's input is transformed into a time domain signal and directly output, the delay in the equalizer can be reduced compared to the conventional technology.

The present invention can also be embodied as computer readable codes on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, and optical data storage devices. The computer readable recording medium can also be distributed over network coupled computer systems so that the computer readable code is stored and executed in a distributed fashion.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A method of decoding an audio signal, the method comprising:
transforming subband sample data of an audio signal into frequency band information items;
adjusting the frequency band information items according to an input; and
transforming the adjusted frequency band information items into subband sample data.

2. The method of claim 1, wherein adjusting the frequency band information items comprises:
adjusting amplitudes of the frequency components mapped onto the frequency band information items according to the input.

3. The method of claim 1 or 2, further comprising displaying the adjusted frequency band information items.

4. The method of any one of the preceding claims, wherein the transforming of the subband sample data into the frequency band information items comprises:
detecting frequency components from the subband sample data; and
grouping the detected frequency components into frequency bands, and mapping each group to one of a plurality of frequency band information items.

5. The method of any one of the preceding claims, wherein adjusting the frequency band information items comprises:
receiving an input adjustment command for a frequency band information item; and
changing amplitudes of all of the frequency components mapped onto the corresponding band information item according to the input adjustment command,
wherein in transforming the adjusted frequency band information items into the subband sample data, the changed frequency components are transformed into the subband sample data.

6. An apparatus for decoding an audio signal, the apparatus comprising:
a first transform unit for transforming subband sample data of an audio signal into frequency band information items;
an adjustment unit for adjusting the frequency band information items according to an input; and
a second transform unit for transforming the adjusted frequency band information items into subband sample data.

7. The apparatus of claim 6, further comprising a display control unit for displaying the adjusted frequency band information items through a display apparatus.

8. The apparatus of claim 6 or 7, wherein the first transform unit comprises:
a detection unit for detecting frequency components from the subband sample data; and
a mapping unit for grouping the detected frequency components into frequency bands, and mapping each group to one of a plurality of frequency band information items.

9. The apparatus of claim 8, wherein the adjustment unit is arranged to adjust amplitudes of the frequency components mapped onto the frequency band information items according to the input.

10. The apparatus of any one of claims 6 to 9, wherein the adjustment unit is arranged to receive an input adjustment command for a frequency band information item, and to change amplitudes of all of the frequency components mapped onto the corresponding band information item according to the input adjustment command, and
the second transform unit is arranged to transform the changed frequency components into the subband sample data.

11. A computer program which, when executed by a processor, is arranged to perform a method according to any one of claims 1 to 5.
